# EUROPEAN PATENT SPECIFICATION

(11) **EP 3 698 407 B1**
(45) Date of publication and mention of the grant of the patent: **02.12.2026**
(21) Application number: 18868497.1
(22) Date of filing: 17.10.2018
(51) Int. Cl.: H10H 29/14, H10H 20/819, H10H 20/841, H10H 20/855

(54) **METHOD FOR MANUFACTURING AN ULTRA-DENSE LED PROJECTOR**
VERFAHREN ZUR HERSTELLUNG EINES ULTRADICHTEN LED-PROJEKTORS
PROCÉDÉ DE FABRICATION D'UN PROJECTEUR À DEL ULTRA-DENSE

(30) Priority: 19.10.2017 US 201762574717 P; 12.12.2017 US 201762597680 P; 12.02.2018 US 201815894712; 08.10.2018 US 201816154603
(43) Date of publication of application: 26.08.2020
(60) Divisional application: 20205527.3 / 3 796 389
(73) Proprietor: Tectus Corporation, Cupertino, CA 95014 (US)
(72) Inventor: CHOY, Kwong-Him, Henry, Saratoga, CA 95070 (US); MARTIN, Paul, Scott, Saratoga, CA 95070 (US)
(74) Representative: Boult Wade Tennant LLP
(86) International application number: PCT/US2018/056199
(87) International publication number: WO 2019/079381

(56) References cited:
- WO-A1-2010/149027
- WO-A2-2011/014490
- WO-A2-2011/029935
- US-A- 4 707 716
- US-A- 5 534 444
- US-A1- 2008 128 728
- US-A1- 2011 226 937
- US-A1- 2012 276 701
- US-A1- 2013 285 086
- US-A1- 2015 279 902
- US-A1- 2016 356 901
- US-A1- 2017 186 907
- US-B1- 6 233 265
- US-B2- 9 196 653

## Description

### BACKGROUND

### 1. Technical Field

This disclosure relates to methods of manufacturing light emitting diode (LED) displays and, in particular, to a monolithic ultra-dense LED display, such as for use in a contact lens.

### 2. Description of Related Art

A conventional LED direct emission display uses discrete red, green, and blue emitting LEDs arranged in an addressable array of composite pixels. Such displays have a fairly large pixel spacing due to the use of separate LED dies. Displays of this type typically have resolutions of up to 500 pixels per inch (composite white pixels/inch) and about a 25 µm (micron) pitch from one colored pixel to the neighboring color pixel.

In another approach, red, green, and blue emitting LEDs are combined on a single die. However, the practical minimum pixel pitch achievable by conventional monolithic LED display technology is about 5-10 µm with pixels several microns in size. Such LED displays may be referred to as micro-displays since each pixel is several square microns in area. Very small displays may require die sizes of 1mm or less. Such an LED display constructed using conventional technology typically is limited in resolution or composite white pixel count.

Accordingly, what is needed are better approaches to forming an ultra-dense (and, therefore, correspondingly higher resolution) LED display.

US2015/279902 discusses a method for producing a light-emitting diode display.

US2017/186907 discusses a vertical current mode solid state device comprising a connection pad and side walls comprising a metal-insulator-semiconductor (MIS) structure, wherein leakage current effect of the vertical device is limited through the side walls by biasing the MIS structure.

WO2011/014490 discusses a pixelated light emitting diode (LED) and a method for pixelating an LED. The pixelated LED includes two or more monolithically integrated electroluminescent elements disposed adjacent each other on a substrate, wherein at least a portion of each electroluminescent element immediately adjacent the substrate includes an inverted truncated pyramidal shape.

### SUMMARY OF THE INVENTION

Various aspects and embodiments of the invention are set out in the appended claims.

### BRIEF DESCRIPTION OF THE DRAWINGS

Embodiments of the disclosure have other advantages and features which will be more readily apparent from the following detailed description and the appended claims, when taken in conjunction with the examples in the accompanying drawings, in which:
Fig. 1A shows a top down view of a frontplane for a femtoprojector display, and a magnified view of a hexagonal LED array within the frontplane.
Fig. 1B shows a schematic diagram of certain circuits on a backplane for a femtoprojector display.
Fig. 2 is a cross-sectional view of three pixels in the display portion of Fig. 1A.
Fig. 3 is a cross-sectional view of the layers in an LED wafer prior to etching the LED wafer to form semiconductor pillars/pixels.
Fig. 4 illustrates a portion of the LED wafer of Fig. 3 after being etched to form trenches surrounding hexagonal pillars, where each pillar acts as an addressable pixel, and after a dielectric layer is formed over the surface.
Fig. 5 illustrates the structure of Fig. 4 after further etching of the trenches through the N-type layer.
Fig. 6 illustrates the sidewalls of the P-type layer and the active layer being coated with a transparent dielectric material to prevent electrical shorting of the PN junction, followed by deposition of a reflective N-metal within the trenches to electrically contact the vertical sidewalls of the N-type layers in the pillars.
Fig. 7A illustrates the top surface of the LED wafer after planarization using CMP, where both the reflective metal over the P-type layer and the N-metal contact are exposed and co-planar.
Fig. 7B is a top down view of the structure of Fig. 7A.
Fig. 8 illustrates the formation of metal contact bumps on top of the anode (P) contact.
Fig. 9 illustrates the bonding of the LED die to a backplane substrate wafer, where electrical connection is made between the anode metal contact on the P-type layer in each pillar and a bump on the backplane substrate wafer for selectively applying an anode voltage to the various LED pixels, and where electrical connection is made between the N-metal contact (cathode common to all pillars) and a bump on the backplane substrate wafer for applying a reference voltage to the various LED pixels.
Fig. 10 again illustrates the bonding of the LED die to the backplane substrate wafer and provides more detail of possible dimensions as well as the backplane substrate construction.
Fig. 11A illustrates the bonded structure after the sapphire growth substrate has been removed from the LED die and after the exposed surface of the LED die have been planarized to expose the N-type layer in each pillar.
Fig. 11B illustrates an alternative bonded structure for use with Cu-Cu bonding where glass (SiO₂) is formed between the copper electrodes, with the top surface of copper and SiO₂ being coplanar.
Fig. 12 illustrates the formation of distributed Bragg reflectors (DBRs) and the deposition of red and green photon energy down converter material over blue pump LEDs to form red, green, and blue addressable pixels having widths less than 1 µm.
Fig. 13 is a top down view of hexagonal metal pads on a top surface of the backplane substrate. The pads may be for Cu-Cu bonding with the LED die or may support gold bumps for bonding to corresponding gold bumps on the LED die.
Fig. 14 illustrates the display portion and how the pixel resolution of the center portion is higher than the resolution of the outer portion to substantially correspond to the varying resolution of the human retina.
Fig. 15 is a cross-sectional view of another type of femto-display, where no down conversion material is used, and all the peak wavelengths of the LED pixels are the same.
Fig. 16 is a cross-sectional view of another type of femto-display, where all the LEDs emit IR light and up-conversion materials are used to create the red, green, and blue emitting pixels.
Figs. 17A-17N show a process for manufacturing the femtoprojector display of Figs. 1A-1B.
Fig. 18 shows a cross-sectional view of adjacent LED pillars from a frontplane for a femtoprojector display.
Fig. 19 shows a cross sectional view of an eye-mounted display containing a femtoprojector in a contact lens.

### DETAILED DESCRIPTION OF THE PREFERRED EMBODIMENTS

The figures and the following description relate to preferred embodiments by way of illustration only. It should be noted that from the following discussion, alternative embodiments of the structures and methods disclosed herein will be readily recognized as viable alternatives that may be employed without departing from the principles of what is claimed.

A "femtoprojector" is a small projector that projects images from a display contained inside a contact lens onto a user's retina. The display and associated optical system are small enough to fit inside a contact lens. To meet this size requirement while still achieving reasonable resolution, the pixel sizes in the image source typically are much smaller than in image sources for other applications. For example, a conventional LED direct emission display uses discrete red, green, and blue emitting LEDs with resolutions of up to 500 pixels per inch (composite white pixels/inch) and about a 25 µm (micron) pitch from one colored pixel to the neighboring color pixel. In contrast, a display for a femtoprojector preferably has pixel sizes of less than 1 µm² in emitting area with a pixel pitch of 2 µm or less, so that when the displayed image is projected onto the retina, the image resolution may also be commensurate with the density of light receptors in the retina.

Disclosed is an ultra-dense LED array suitable for use in a monolithic "femto-LED display" (or femtoprojector), which has a resolution that preferably substantially matches or exceeds that of the human retina. The design preferably allows the pixel sizes to be less than 1 µm² in emitting area with a pixel pitch less than 2 µm such that when the displayed image is projected onto the retina, the retinal image has a similar resolution as that of a real image being augmented or replaced. In one example, the spacing between pixels is less than 0.2 µm and a preferred pixel diameter is about 0.5 µm. If each pixel was square, its area would be about 250x 10⁻¹⁵ m² (or 250 square femto-meters).

In one approach, the higher density of LED pixels can be created by forming a single LED die and etching the die to form a dense array of separately addressable LED pixels. Such LED pixel segments can be as small as several microns across or less. If the LED die is GaN based and the LEDs emit blue light, the segments for the red and green pixels can be formed by depositing photon energy down-converting phosphors over the blue LEDs. Alternatively, if the LED die emits in the IR, red, green, and blue pixels can be created by depositing energy up-converting materials over the IR LEDs.

One possible use of such a monolithic ultra-dense LED display is to embed the display in a contact lens so that the displayed image overlays the wearer's view of the real world. The LED display may be less than 1mm across, so it would not be visible to someone looking at the wearer and would also not substantially block light from the real world coming into the wearer's pupil. The display directly projects onto the wearer's retina.

Another possible use of the monolithic ultra-dense LED display is in eyewear, such as glasses or goggles, to create an immersive visual experience or an image that overlays the wearer's view of the real world, such as in an augmented, mixed, or artificial reality application. The LEDs in such an ultra-dense display may be distinguished from conventional LEDs by the aspect ratio of their height (or thickness) to width. Conventional LEDs are flat with aspect ratios (height:width) from less than 1:100 to 1:2. The ultra-dense LEDs disclosed herein are taller than their widths with aspect ratios (height:width) greater than 1:1 and preferably greater than 5:1. These LEDs can be visualized as an array of closely spaced "soda can" shaped LEDs having aspect ratios ranging from similar to a 12 ounce soda can (2:1) to similar to 5 soda cans stacked on top of each other (10:1).

In one example, one surface (opposite the growth substrate) of the LED pixels is a P-type layer, and the growth substrate is removed to expose the underlying N-type layer. Each pixel forms a thin pillar of semiconductor material. The sub 1 µm² area of the top and bottom surfaces of the pillars and the small space (e.g., sub 0.5 µm) between neighboring LEDs makes it difficult to efficiently electrically contact the N-type layer "underneath" the P-layer and conduct current. A preferred example provides a fill between the pillars. In one example, this fill is a reflective N-metal (e.g., Al, Ag, Ni/Ag, Ti/Al) vertically surrounding and filling the space between the LED pillars to electrically contact the N-type layer along its vertical sidewall. Thus, there is a relatively large cathode contact area for low resistance and good current handling capability. This sidewall contact is further utilized to provide mechanical support for and optically isolate the individual LED pixels. The reflective N-metal, and any reflective metal overlying the N-metal, surrounding each LED pixel prevents optical cross-talk between pixels and improves efficiency. The reflective metal performs the combined functions of electrically conducting current, optically isolating the pixels, reflecting back light into the pixels, and mechanically supporting the pixels. In alternate examples, the fill between pillars may include other metals or materials in addition to the reflective N-metal.

In examples that utilize photon energy down-conversion, in one approach, for the red and green pixels, blue emission LEDs are covered with a wavelength conversion material, such as phosphor or quantum dots, to convert from blue to the desired pixel color.

In examples that require photon energy up-conversion, in one approach, IR LEDs are covered with a photon energy up-conversion material to convert from the IR wavelength to the appropriate pixel color of red, green or blue.

Reflective aluminum may surround the color conversion portion of the pixels, where the aluminum contacts the top surface of the N-metal. The N-metal and aluminum form a mesh around the pixels. Optical isolation between the pixels is useful to maintaining high resolution color images, and the high aluminum reflectivity maintains high efficiency.

Preferably, for use in imaging directly onto the retina, such as is done with a contact lens display, the pixels may form a honeycomb pattern (i.e., hexagonal array).

A distributed Bragg reflector (DBR) may be formed over the display to enhance directionality.

The resolution of the retina varies substantially from a peak in the fovea to a lower resolution toward the periphery. The desirability for a contact lens-based retinal projection display, where the resolution and shape of the LED pixels vary as a function of position, poses substantial challenges. The "soda can" LED array design described in this disclosure is good because the display is monolithic, with pixel sizes and shapes that can be defined photolithographically to match the variable resolution of the human eye. By varying the pixel resolution to match the varying resolution of the retina, the die area is used most efficiently by not providing a resolution that is higher than can be perceived by the human eye.

In order to address the pixels in the monolithic LED display, the LED display is mounted on a backplane substrate containing addressing circuitry.

After the formation of reflective P-metal contacts on the P-type surfaces of the pillars, and after the spaces between the pillars are filled with the N-metal to contact the N-type layers of the pillars, the top surface of the LED wafer is planarized, such as using chemical mechanical polishing (CMP), to form planar metal anode and cathode contacts. The LED wafer is then singulated, and the die are bonded to the backplane substrate wafer containing the addressing circuitry. The anode and cathode contacts of the LED die are on the same planar surface, and the array of metal contacts on the backplane substrate wafer is also planar for reliable bonding. The LED die may be less than 1mm in diameter. Copper-copper bonding is preferred for bonding the LED die to the backplane substrate wafer.

The growth substrate is then removed from the bonded LED die, thus exposing the light emitting surface of the pixels.

In one example, the color conversion layer is formed as a separate die layer and separately bonded over the light emitting surfaces of the LED dies. The backplane substrate is then singulated.

The wavelength conversion layer preferably is thin yet blocks the blue pump light so as not to sacrifice the purity of the color emitted from the conversion layer. One technique is to form a polymer matrix that deterministically arranges quantum dot crystals for good conversion and reduced absorption of the converted light. Also important to fabrication of the color conversion layer is separation of individual pixels with a reflective metal, such as aluminum, so that photons converted in the layer are reflected back from the sides and emit only from the top. Thus, photons from, for example, a green pixel are not emitted laterally into a red pixel area.

The monolithic display can be either embedded in a contact lens or be part of eye glasses or goggles that project the image onto the wearer's retina. The display may also be added to a smartphone to provide a projector function.

In another aspect, gallium nitride (GaN) is a common material system used to fabricate LEDs. In a typical fabrication process, GaN layers are deposited on a substrate such as sapphire. From the substrate upwards, the GaN region may include a buffer region, an n-doped region, an active region (e.g., InGaN quantum wells) and a p-doped region. The distance from the substrate to the active region (i.e., buffer region plus n-doped region) may be especially thick, for example 5um or more, because the first several microns of GaN that are directly adjacent to the substrate typically is of poor quality. This is sometimes referred to as a buffer region. Accordingly, the GaN region is grown thicker so that the material farther away from the substrate has the desired quality. If the pixels have small area, as is the case in femtoprojectors, the resulting LED structures can be tall and skinny, for example 5um tall pillars with a 1um wide active area. This is undesirable because light produced by the active area reflects many times off the sidewalls before leaving the LED pillar, resulting in higher optical loss. High aspect ratio structures may also create fabrication difficulties. It is more difficult to etch deep, narrow trenches, and also more difficult to fill them with metals and/or other materials.

As a result, it is beneficial to reduce the thickness of this GaN region. In one approach, a wafer with the GaN region on substrate is bonded to a backplane wafer containing LED driver circuits. The substrate is separated from the GaN region, exposing the buffer layer of GaN which is made thinner first by chemical mechanical polishing and then etching. Thinning removes the buffer layer and reduces the height of the LED pillars, which in turn reduces optical loss. Furthermore, if trenches are etched to separate the GaN region into individual LED pillars, then thinning the GaN region reduces the aspect ratio of the trenches, which makes the etching process less challenging.

Other examples are described.

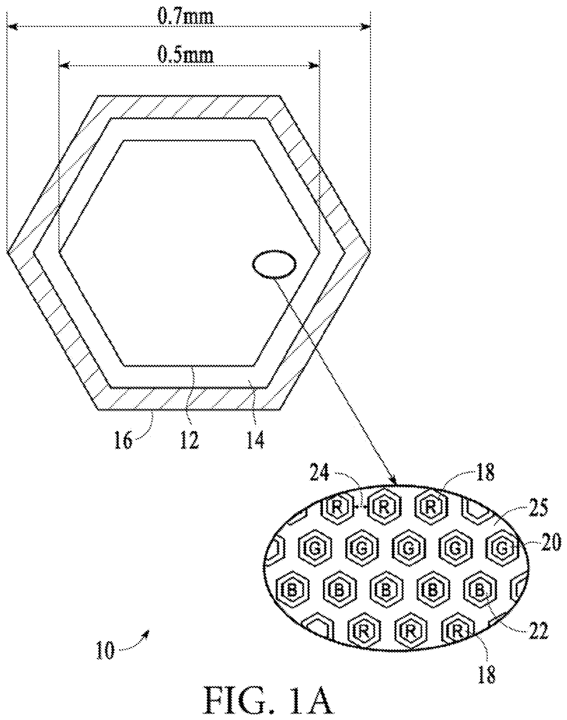

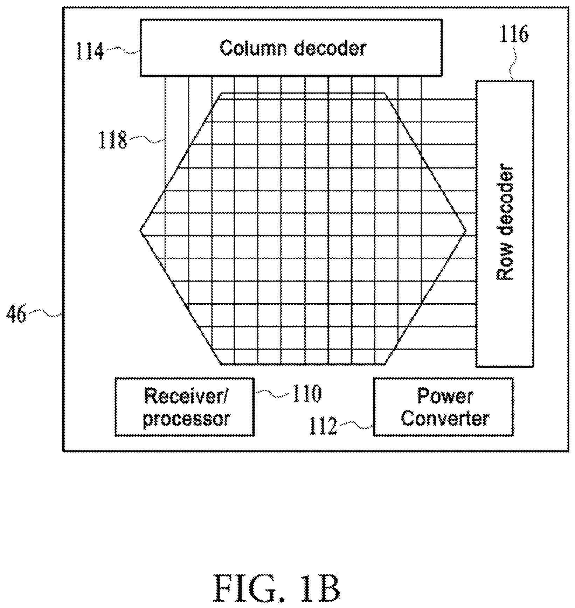

In many examples, the femtoprojector display includes a frontplane and a backplane. Fig. 1A is a diagram of the frontplane, which contains an LED array. Fig. 1B is a diagram of the backplane, which contains addressing and drive circuitry.

Fig. 1A shows a top down view of a frontplane 10 for a femtoprojector display, and a magnified view of the hexagonal LED array within the frontplane. In one application, the ultra-dense LED display using this frontplane 10 may be used as a projector in a contact lens to project an image directly onto a wearer's retina. The LED array within this frontplane 10 is shown as having a hexagonal shape, but other shapes are possible. A die containing the frontplane may have a rectangular shape. The dimensions in the following descriptions are also examples.

The frontplane 10 includes a central pixel area 12, a dead space area 14, and an n-ring area 16. The area 16 is a termination area to electrically connect one contact of all the LEDs in the array to a common electrical contact on the backplane. The diameter of the frontplane components shown may be about 0.7mm, and the diameter of the pixel area 12 may be about 0.5mm. The width of each pixel is less than 2 µm and preferably about 0.6 µm. In one example, the display contains more than 400,000 pixels with variable sizes of pixels from a minimum of 0.6 µm to a maximum of 2 µm.

Also shown in Fig. 1A is an expanded view of a portion of the pixel area 12, showing red pixels (R) 18, green pixels (G) 20, and blue pixels (B) 22. In one example, the LEDs are GaN-based LEDs and the active layers of the LEDs within the pixels output blue light. The red and green pixels are formed using a phosphor, quantum dots or other color-conversion mechanisms to down convert the blue pump light to longer wavelengths. The gap 24 between pixels is less than 0.5 µm and preferably about 0.2 µm to increase the density, fill-factor, and resolution of the display. The space 25 between the pixels is filled with a reflective metal, such as aluminum.

The die may be rectangular, even though the display portion 10 is hexagonal. The die may also contain various silicon circuitry for processing image signals, powering the device, addressing the pixels, etc.

Fig. 1B shows a schematic diagram of certain circuits on a backplane 46 for use with the femtoprojector frontplane 10 of Fig. 1A. Fig. 1B schematically illustrates one possible addressing technique used on the backplane 46 for addressing a particular pixel by applying a voltage to the associated contact for that pixel. The die may be about 0.5-1mm wide.

Image signals may be transmitted to the backplane 46 using wireless or other means. In one example, radio frequency signals (e.g., about 13 MHz) are received by an antenna and processed by a receiver/processor 110. Power for the backplane 46 may be received by the antenna via resonant inductive coupling and converted to the appropriate voltage and polarity by a power converter 112. The power signal and the image signals may be at different frequencies so that the signals can be separated. The power converter 112 and receiver/data processor 110 may be integrated into the backplane chip 46 or integrated into a separate power/data chip with the data receiver/processor 110 and the power converter 112 electrically connected to the display backplane 46 by conductors. The small size allows the femtoprojector display to be encased in a contact lens. The image signals may include addressing signals that are decoded by a column decoder 114 and a row decoder 116. Traces 118 in the device layer of the backplane 46 form an array of pixel locations. Control voltages on a selected column line and row line turn on a transistor for conducting current to the selected pixel. The color brightness may be controlled by pulse width modulation, by amplitude modulation or by other means. Low power CMOS switches may be used to address pixels. The relative brightness of the red, green, and blue pixels in a single full color pixel determines the perceived color for that composite pixel.

In an example of the display being incorporated in a contact lens, the power converter 112 and receiver/processor 110 may be separated from the backplane 46 in a separate chip, and both chips may be separately encased in the contact lens. The power/data chip is located away from the pupil so as to not obstruct vision. Small wires connect metal pads on the backplane 46 to metal pads on the power/data chip. A thin wire loop antenna is also connected to pads on the power/data chip and encased in the contact lens.

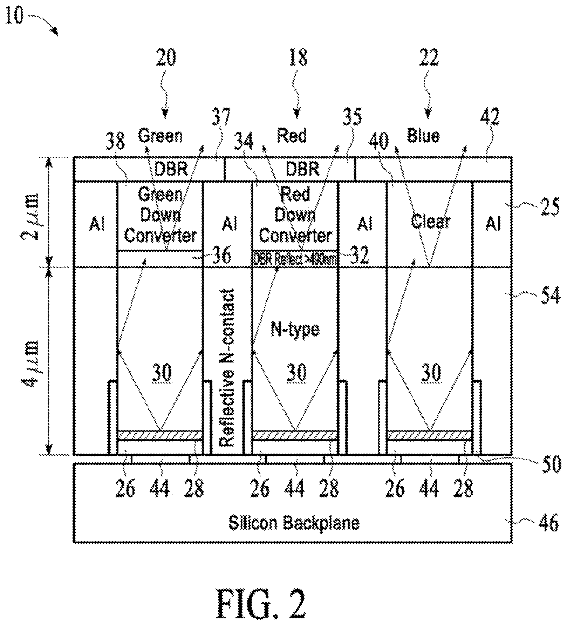

Fig. 2 is a cross-section of Fig. 1A taken through a red pixel 18, a green pixel 20, and a blue pixel 22. As seen, the pixels are much taller than wide. The height of the semiconductor LED portion of the pixels may be about 4 µm, while the width may be about 0.6 µm. The height (i.e., thickness) of the wavelength conversion material may be less than 2 µm. The GaN semiconductor regions are optically isolated from each other and electrically connected to each other by the reflective metal N-contact 54 filling the space between the pixels.

The red pixel 18 includes a thin P-type layer 26, an active layer 28, a relatively thick N-type layer 30, a distributed Bragg reflector (DBR) 32 that passes blue light but reflects red light, and a red down converter 34 such as a phosphor or quantum dots. Overlying the red down converter 34 may be a reflective DBR 35 that reflects blue light but passes red light.

The green pixel 20 is identical to the red pixel 18 except that the DBR 36 reflects green light, and a green down converter 38 overlies the blue pump LED. Overlying the green down converter 38 may be a reflective DBR 37 that reflects blue light but passes green light.

The blue pixel 22 is identical to the red pixel 18 except that no DBR or wavelength converter is needed. A clear dielectric material 40 and protective layer 42 may be formed over the blue pump LED to maintain planarity with the red and green pixels. If the blue pump light is not the desired blue display wavelength, such as when using deep blue light <430nm, a suitable DBR and down converter material may be used to generate the desired blue display wavelength, which is preferably in the range of 455nm to 470nm.

A protective transparent oxide layer (not shown) may be formed over the top of the display.

Reflective P-metal electrodes 44 (anode electrodes) are formed on the P-type layer 26 and electrically contact associated metal pads on a backplane substrate 46. They also increase optical efficiency by reflecting light towards the desired output face. The substrate 46 may comprise silicon and includes addressing circuitry.

After the LED semiconductor layers are formed, they are masked and etched (e.g., by RIE) to form hexagonal trenches around each pixel area. These trenches form pillars of the semiconductor layers in a honeycomb pattern. The trenches are substantially vertical but may have a slight inward angle due to RIE etching characteristics.

A transparent dielectric material 50, such as oxide or nitride, is formed around the bottom portion of each LED sidewall to insulate the sides of the P-type layer 26 and active layer 28 in the region of the PN active junction. This may be done using masking and etching steps. The sidewalls of the N-type layer 30 are exposed.

A reflective N-metal 54 (cathode electrode) is then deposited in the trenches between the hexagonal pixels to electrically contact a large vertical sidewall area of the N-type layer 30. Preferably, over 80% of the height of the pillar is electrically contacted by the N-metal 54. The N-metal 54 may include nickel, silver, gold, aluminum, titanium, alloys thereof, or other reflective metal to achieve at least 80% reflection and may include multiple metal layers. Reflectivity and low resistance metal-semiconductor contact are important for the metal in immediate contact and within 100nm of the N-type layer 30. Further away from N-type layer 30 can be other metal layers chosen for mechanical strength, thermal conductivity and electrical conductivity, such as copper. The side light passing through the dielectric material 50 is also reflected back by the N-metal 54. Accordingly, virtually all light generated by each blue pump LED will be emitted from the top surface (through the top of the N-type layer 30) and there will be virtually no cross-talk between pixels. The N-metal 54 also serves to mechanically support the pillars and distribute heat.

The blue light then passes through the DBR 32/36 to be converted by the red or green down converter material 34/38. The DBRs 32/36 pass the blue light but reflect back the red or green light so there is high efficiency.

Aluminum 25 is deposited over the N-metal 54 in the trenches between the hexagonal pixels to surround the DBRs 32/36, down converter material 34/38, and clear dielectric material 40. The aluminum 25 provides high reflectivity to limit cross-talk.

The N-metal 54 extends to the N-ring area 16 in Fig. 1A surrounding the display 10. The N-ring area 16 is bonded to a cathode electrode on the backplane substrate 46. In another example, the aluminum 25 terminates in one or more electrodes along the perimeter of the display 10 for contacting a cathode electrode on the substrate 46.

Substantial heat may be generated by the LED pixels and in the down-converting layer above the pixels. The combination of the N-metal 54 and aluminum 25 provides a good heat conductor for removing heat from a large area of the LEDs in the pixel array and in the down-converting array and spreading the heat across the entire width of the die.

In a preferred design, the individual RGB pixels are optically fully isolated with no substantial optical path between pixels, thus preventing degradation of the resolution of the display and maintaining a large color gamut. The device preferably has optical isolation between neighboring pixels greater than 1000:1 and a color gamut defined by blue, red and green primaries with greater than 1000:1 exclusion of light from neighboring pixels.

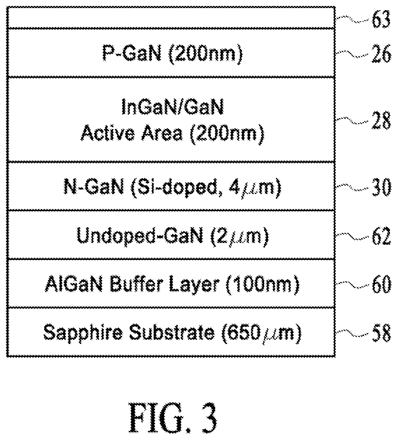

Figs. 3-12 illustrate some example fabrication techniques. Fig. 3 illustrates the various layers in the LED wafer forming the pump LEDs. The layers are epitaxially grown over a sapphire substrate 58, which is later removed after the LED die are bonded to the silicon backplane substrate 46.

An AlGaN buffer layer 60 is grown over the sapphire substrate 58, followed by growing an undoped GaN layer 62, the N-type layer 30, the active layer 28, and the P-type layer 26. A reflective metal (e.g., Ni/Au/Al, ITO/Al, Ni/Ag, Ag) anode contact 63 is formed over the P-type layer 26 to electrically contact the P-type layer 26.

Metal anode contact 63 is deposited on the planar epi wafer and annealed to form a low resistivity reflective anode contact. Alternatively, a liftoff technique is used to deposit the metal anode contact 63 in the form of the pixel contact.

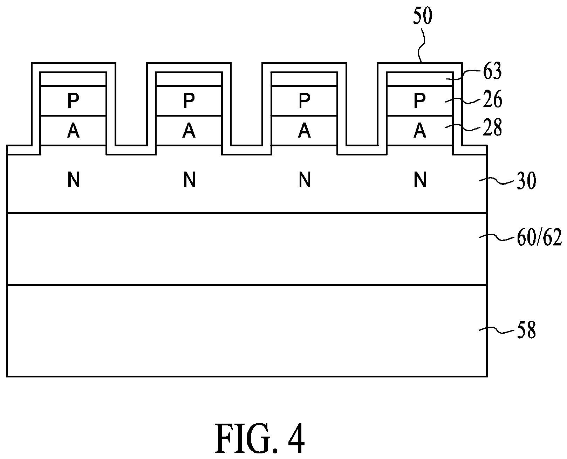

In Fig. 4, the various LED semiconductor layers and metal anode contact 63 are masked and etched to form trenches around each hexagonal pillar. Each pillar will be a primary color pixel about 0.5-1 µm wide, with a gap between pixels of about 0.6 µm or less. The etching depth is below the PN junction. A dielectric material 50 is formed over the metal anode contact 63, P-type layer 26, and insulates the PN junction in the active layer 28. The preferred transparent dielectric material 50 is SiO₂, SiN, or Al₂O₃. These are chosen for their optical transparency, high electrical breakdown voltage, and availability of pinhole-free deposition techniques. For Al₂O₃, a thin aluminum layer may be formed using atomic layer deposition (ALD) followed by wet oxidation of the Al layer. The dielectric sidewall thickness is preferably less than 0.05 µm.

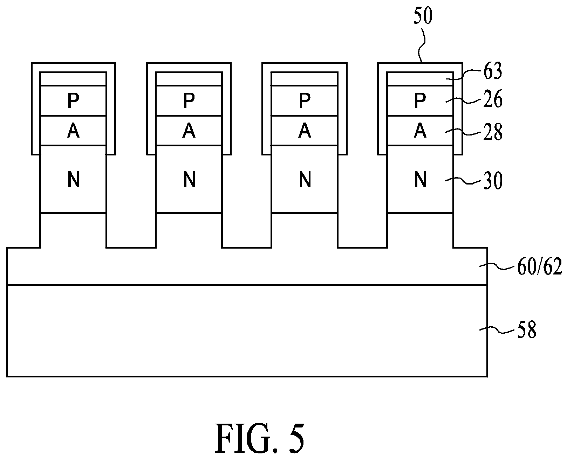

In Fig. 5, the etching of the gap between the pixels is extended through the transparent dielectric material 50 in the bottom of the etched trench down below the N-type layer 30 and optionally down to the substrate 58. The sides of the N-type layer 30 are exposed. The N-type layers 30 of each pillar are isolated from each other. There is no contiguous N-type layer connecting adjacent pillars.

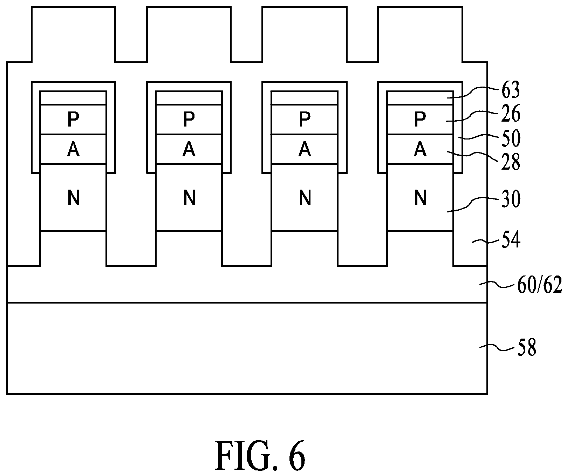

As shown in Fig. 6, a suitable reflective N-metal 54 (e.g., Al, Ti/Al) is deposited in the trenches and over the pillars. The N-metal 54 electrically contacts the sides of the N-type layer 30 but is insulated from the anode contact 63, P-type layer 26, and active layer 28 by the dielectric layer 50. Since a large area is contacted by the N-metal 54, there is good current spreading, consistent cathode voltage between pixels, and low contact resistance.

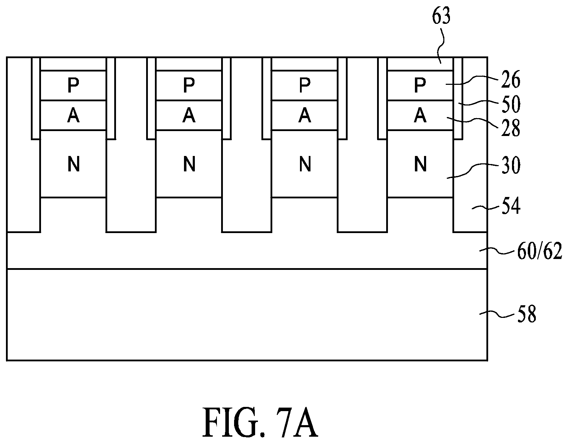

As shown in Fig. 7A, a chemical mechanical polishing (CMP) process is performed to planarize the top surface and expose the anode contact 63, the cathode contact 54, and the dielectric 50 on the same plane.

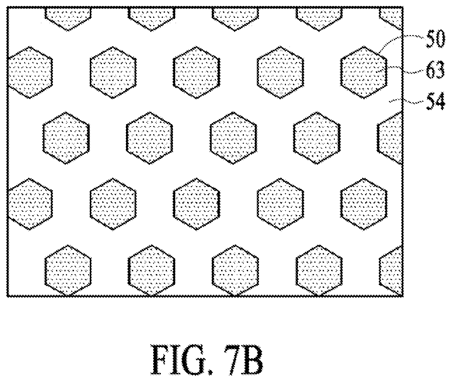

Fig. 7B is a top down view of the structure of Fig. 7A and shows the pixel area after CMP, where the top surface containing the anode contact 63, N-metal (cathode) 54, and dielectric material 50 is planar.

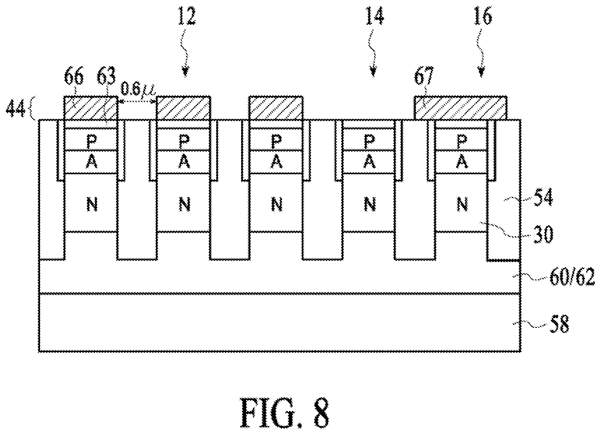

In Fig. 8, metal bumps 66 are formed over the anode contacts 63 and, at the same time, metal bumps 67 are formed in the N-ring area 16 electrically connected to the N-metal 54. Note that the LED pillars under the N-ring area 16 are shorted by the metal bumps 67 and do not emit light by design. The combination of the anode contacts 63 and metal bumps 66 forms the P-metal electrodes 44 in Fig. 2.

Preferred bump materials include indium, tin, AuSn, gold, and copper. The planarity of the "soda-can" LED device after CMP and the small area of the display make the soda-can LEDs compatible for using Cu-Cu bonding to Cu pads on a silicon CMOS backplane wafer. Cu-Cu bonding requires planarity of less than few nm across the array, which is enabled by the soda-can LED device design.

The LED wafer is then singulated, and the LED die are bonded to a silicon backplane wafer as described below.

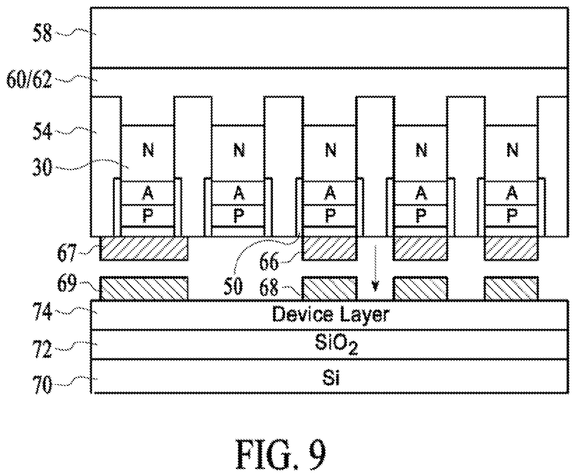

In Fig. 9, the metal bumps 66 and 67 on the LED die are bonded to corresponding metal bumps 68 and 69 on a silicon backplane substrate 46, also shown in Fig. 2. Ultrasonic bonding (typically using gold bumps) or thermo-compression In-In bonding or Cu-Cu bonding may be used.

Mating bump metals can include Au-Au, AuSn-Au, In-In, Sn-Sn, and most preferably Cu-Cu. Cu-Cu is not used in conventional LED array manufacturing because of the extreme flatness required on both the backplane and the device side (typically < 2nm RMS flatness over the Cu-Cu contact area of entire array). The soda-can LED device structure is designed to match with requirements of Cu-Cu bonding, such that surface anode and cathode contacts are co-planar by CMP preferably to within 2nm. The cathode contact is shown on the left side of Fig. 9 and is the preferred design of the N-ring area 16 shown in Fig. 1A, formed along edges of the die on the same surface as the anode contacts and electrically connected to the N-metal 54. CMP may be performed after the metallization step to planarize the anode and cathode bumps (e.g., Cu). Each LED anode and cathode bump is less than a few microns across, such as less than one micron across, so that dishing during CMP of Cu can be minimized to less than a few nm over the entire array, which may be less than 1mm across.

The substrate 46 comprises silicon 70 with an insulating oxide layer 72. MOSFET drivers, addressing circuitry, and various conductors are located in a device layer 74. Other types of substrates may be used. For example, the oxide layer 72 may be deleted. The gold bumps 66 and 68 may be deposited on hexagonal metal pads to match the shape of the pillars. As previously mentioned, Cu-Cu bonding can also be used.

The remaining figures are out of the field of view of the N-ring area 16.

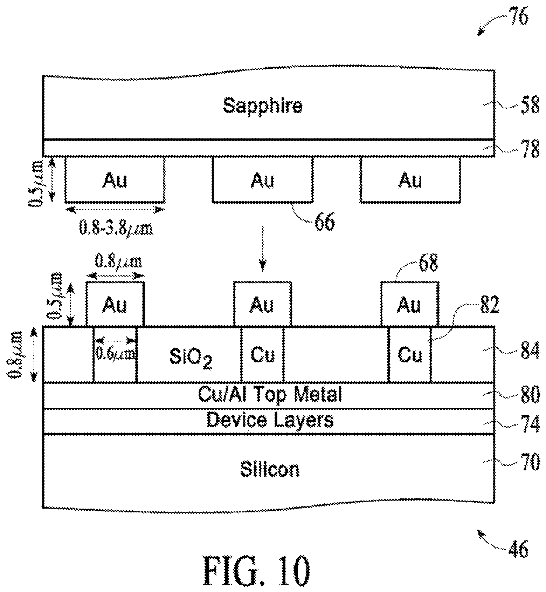

Fig. 10 is a simplified view of the LED die 76 showing the sapphire substrate 58, semiconductor layers 78, and gold bumps 66. The backplane substrate 46 is shown without an oxide layer. Conductive traces are represented by the Cu metal layer 80. Copper contacts 82 electrically contact the conductors, and an oxide layer 84 is between the copper contacts 82. The gold bumps 68 are formed over the copper contacts 82. In some examples, the oxide layer can extend to top surface of the gold bumps 68.

To energize a pixel, a voltage is applied between a gold bump 68 on the substrate 46, electrically contacting a P-type layer of one of the pillars, and another gold bump on the substrate 46 electrically contacting the N-metal 54 (Fig. 2), via the N-ring area 16 of Fig. 1A, which electrically contacts all the N-type layers 30 of the pillars. The N-metal 54 may be connected to ground, and the gold bumps 68 are connected to address circuitry, such as using row and column lines, where an energized intersection of a column line and row line lights up the pixel at that location. A transistor may be at each pixel location in the device layer 74 to apply a voltage/current to the corresponding gold bump 68. This is referred to as an active matrix. In one example, CMOS circuitry is used to address a pixel, and a digitally controllable current source applies a variable current to that pixel to control its brightness. Conventional addressing techniques may be used.

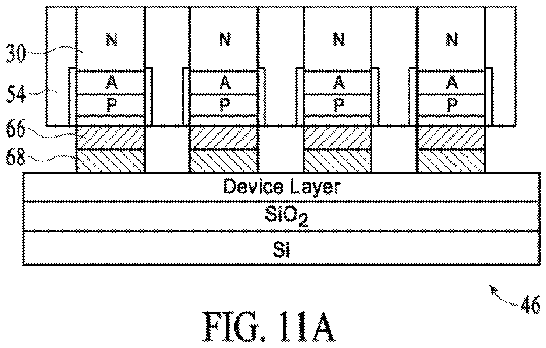

Fig. 11A illustrates the bonded structure after the sapphire substrate 58 (Fig. 9) has been removed by laser lift-off. In one example, the trench is etched down to the substrate leaving no semiconductor connection between LED pillars after the sapphire substrate 58 is removed. In another example, the AlGaN buffer layer 60 (Fig. 3) and the undoped GaN layer 62 have been removed by etching after the removal of the substrate 58 to isolate the individual LED pillars. In all cases, the side of the LED previously connected to the sapphire substrate 58 is planar. The backplane substrate 46 provides mechanical support.

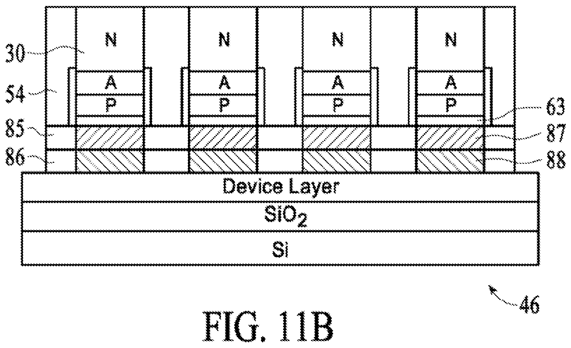

Fig. 11B illustrates a variation on the bonded structure of Fig. 11A, where the bonding is Cu-Cu bonding. Glass 85 (SiO₂) is formed around each of the LED pixels, such as by deposition and CMP down to expose the copper anode contacts 63 and cathode contacts. The glass 85 is not formed over the reflective anode contacts 63. A similar glass 86 layer is formed over the substrate 46. A copper seed layer is formed in the openings of the glass 85 and 86 if plating is to be used. Then, copper 87 and 88 is plated or otherwise deposited to fill the open areas of the glass 85 and 86. The LED wafer surface and the substrate 46 surface are then polished using CMP so that both surfaces are planar (planarity within 2nm). The copper 87/88 forms electrodes for the substrate 46 and LED pixels. The copper 87/88 is then made to be slightly recessed using a short wet etch of the copper 87/88, if there is insufficient dishing of the copper during the CMP planarization.

The LED wafer is then diced, and the die are then bonded to the substrate 46 wafer as follows. The LED die are aligned with the substrate 46 wafer and the structures are pressed together (e.g., at 100 psi) under heat (e.g., 200°C) so that the glass 85/86 surfaces bond. As the heat is raised (e.g., to 300°C), the thickness of the copper 87/88 expands greater than the thickness of the glass 85/86, and the opposing copper electrodes contact each other to form a low resistivity contact. Cu atoms diffuse to also create a good mechanical bond. The temperature expansion coefficient of copper is about 16 ppm/C, while the temperature expansion coefficient of glass is about 0.6ppm/C. The bonding process may take 30 minutes.

In this configuration, bonding happens first between the SiO₂ on the silicon backplane side and the SiO₂ on the LED side at a low temperature of -200°C under thermal compression. Subsequently, the bonded wafer is heated above 200°C such that the copper on both the silicon backplane and the LED device side expand sufficiently to contact each other and make a thermo-compression bond. The compression in this case is only due to the difference in thermal expansion coefficients between SiO₂ and copper.

The remaining figures assume the bonding technique of Fig. 5A is used, but either bonding method may be used.

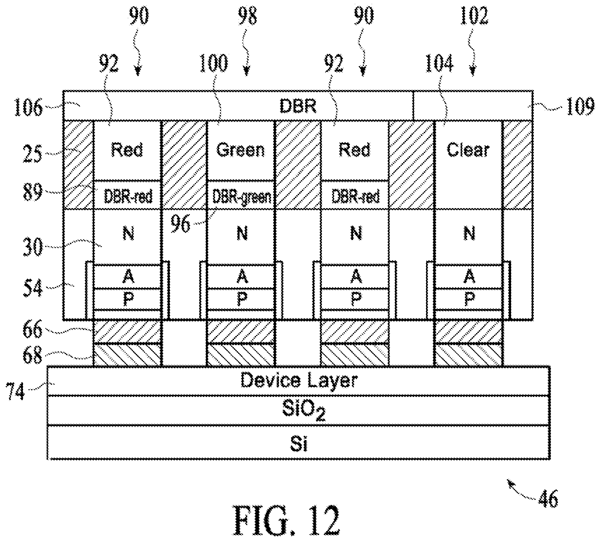

In Fig. 12, a DBR 89 is formed over the blue pump LED pillar for a red pixel 90.

The DBR 89 comprises many layers that, in conjunction, pass blue light but reflect red light. In this way, red light is not absorbed by the LED. A red down converter material 92 overlies the DBR 89. The down converter material may be phosphor or quantum dots.

Similarly, a DBR 96 is formed over the blue pump LED pillar for a green pixel 98. The DBR 96 passes blue light but reflects green light. A green down converter material 100 overlies the DBR 96. The down converter material may be phosphor or quantum dots.

Over the blue pixel 102 is a clear dielectric 104 so the top surface is planar.

In the hexagonal gaps between the down converter material of adjacent pillars is deposited aluminum 25. The aluminum 25 surrounding the pillars forms a reflective containment of converted light to prevent optical cross-talk between different color pixels within the color conversion layer. The aluminum 25 also helps mechanically support the down converter material and define its shape. A top down view of Fig. 12 is similar to the magnified portion in Fig. 1A.

The thickness of the down conversion material should be thin to maximize efficiency and to minimize the height of the entire device. For quantum dots, such thickness should be on the order of 1.5 µm. State of the art color conversion layers are 10-50 µm thick, so special design considerations must be taken to convert greater than 99% of the pump blue light to the desired color. Conversion of greater than 99% of the pump blue light to the desired color is desirable to maintain color purity of the converted color pixels and thus maintain a good color gamut of the entire RGB display. One technique is to form a polymer matrix that deterministically arranges quantum dot crystals for optimal conversion and maximum solid density. Quantum dot densities > 1021/cm3 for quantum dots of diameter 6nm are preferred to achieve more than 99% conversion within 1.5 µm thickness.

A DBR 106 may be deposited over the top of the display to reflect the incident pump blue light to reduce the leakage of pump light through the color converted pixel. The DBR 106 can also be designed to partially collimate the pixel emission. In the case shown in Fig. 12 where blue light directly from the LED is used for the blue pixel, the reflective DBR 106 is removed from the area above the blue pixel. In one example, the area above the blue pixel is replaced with a clear dielectric 109 which can be planarized, for example, by CMP.

The wavelength conversion layers over the N-type layer 30 may be formed as a separate wafer or die and then bonded to the top of the LED die or LED wafer.

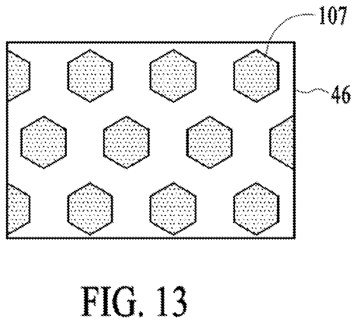

Fig. 13 is a top down view of hexagonal metal pads 107 on the backplane substrate 46 that support the gold bumps 68 (Fig. 11), corresponding to the gold bumps 66 on the LED die. The metal pads 107 may instead be copper for Cu-Cu bonding to the LED die.

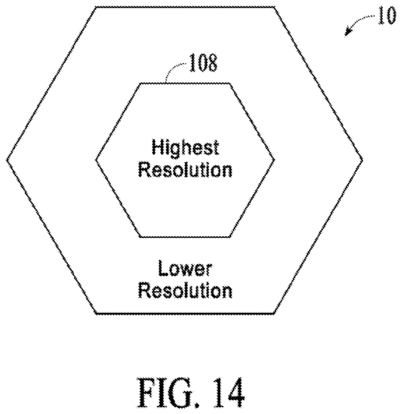

Fig. 14 illustrates how the pixel density (resolution) is reduced away from the center portion 108 of the display 10. The display 10 projects its image directly onto the retina. The retina has a central fovea which contains the densest concentration of cones. Outside of the fovea, there is a lower density of cones. Accordingly, there is no need for the display 10 to have a high resolution outside of its central area 108. This improves the efficiency of the display 10 since the resolution is not higher than required outside of the fovea area. The resolution of the display 10 in the center area 108 should be indistinguishable from the perceived resolution of the real world by the fovea. The resolution of the display outside the central region can smoothly decrease consistent with the decrease in resolution of the retina away from the fovea. Accordingly, the displayed image may be indistinguishable from reality over the entire displayed image, including the part of the image in the high resolution fovea and as the resolution drops moving away from the central foveal region.

In the fovea area, a 20/20 resolution on the retina needs a pitch between white (RGB composite) pixels of about 6 µm on the retina. If the display is encapsulated in a contact lens, the display will be about 25mm from the retina. If the optic in front of the display has a magnification of about 3X and a white composite pixel is made up of RGGB pixels, then the pitch between white pixels on the display must be less than 2 µm (6 µm/3) and the pitch between individual color pixels must be further reduced by factor of 2 and therefore must be less than 1um. There is a desire to keep the display less than 1mm in size so as not to substantially block the real world light entering the pupil. A minimum pupil size is typically 2mm in diameter, meaning that a 1mm diameter circular obstruction would block about 25% of the real world light for a minimum pupil size of 2mm diameter. In order to image on the retina a substantial Field of View (FOV), the center foveal pixel spacing in the LED display should be at a pitch less than 1um in order to display images on the retina indistinguishable from reality. The pitch is thus less than the height of each pixel (pillar).

The sizes of the LED pixels may be varied across the display to achieve a projected image that matches the resolution of the retina, with the highest resolution at the center of the fovea.

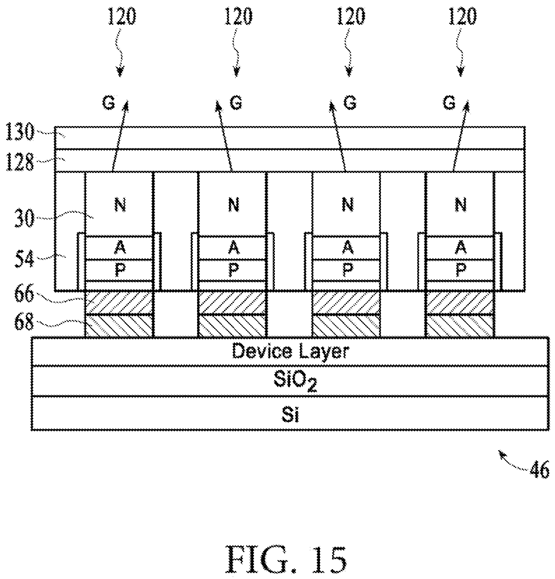

Fig. 15 schematically illustrates one possible addressing technique used in the backplane substrate 46 for addressing a particular pixel by applying a voltage to the associated gold bump 68 (Fig. 12) for that pixel. The die may be 0.5-1mm across. Image signals may be transmitted to the backplane substrate 46 using RF or other means. In one example, radio frequency signals (e.g., about 13 MHz) are received by an antenna and processed by the receiver/processor 110. The power converter 112 and receiver/data processor 110 can be integrated into the display backplane or integrated into a separate power/data chip with the data receiver/processor 110 and the power converter 112 electrically connected to the display backplane by wires. Power may be received by the antenna via resonant inductive coupling and converted to the appropriate voltage and polarity by a power converter 112. The power signal and the image signals will be at different frequencies so that the signals can be separated out on the substrate 46 using appropriate coupling circuits on the substrate 46. This allows the monolithic display die to be encased in a contact lens or the lens of glasses. The image signals include addressing signals that are decoded by a column decoder 114 and a row decoder 116. Traces 118 in the device layer of the substrate 46 "intersect" at each pixel location. Control voltages on a selected column line and row line turn on a transistor for conducting current to the selected pixel. The color brightness may be controlled by PWM or by the magnitude of the current. Low power CMOS switches may be used to address pixels. The relative brightness of the red, green, and blue pixels in a single full color pixel determines the perceived color for that composite pixel.

In an example of the display being incorporated in a contact lens or a lens of glasses, the power converter 112 and receiver/processor110 are separated from the backplane substrate 46 in a separate chip, and both chips are separately encased in the contact lens or the lens of the glasses. The power/data chip is located away from the pupil so as to not obstruct vision. Small wires connect metal pads on the backplane substrate 46 to metal pads on the power/data chip embedded in the lens. A thin wire loop antenna is also connected to pads on the power/data chip and encased in the lens.

All fabrication processing preferably is performed on a wafer scale. The LED wafer is diced and individual, or groups of, LED dies are attached to the backplane substrate 46 wafer, as described above. If the color conversion layers are formed as separate die, the color conversion die are then attached to the LED die on top of the backplane substrate 46 wafer, which is then singulated to form separate display die (i.e., a substrate die bonded to an LED pixel die), having edges less than 1mm.

In the example disclosed above, all the LEDs emitted blue light, and down converter material was used to create red and green light. Fig. 15 illustrates a technique where a monochrome display is fabricated. Thus, no wavelength conversion material is needed. All the LEDs are GaN based to generate a single color, such as blue or green, or the LEDs are AlInGaP based to generate a single color such as red or amber., Schematically illustrated are four green LEDs 120. The reflective N-metal 54 electrically contacting the N-type layers and surrounding the hexagonal pillars may be the same as that previously described. The gold bumps 68 contacting the P-type layers may be the same as previously described. A DBR layer 128 may provide collimation. A transparent oxide layer 130 protects the device.

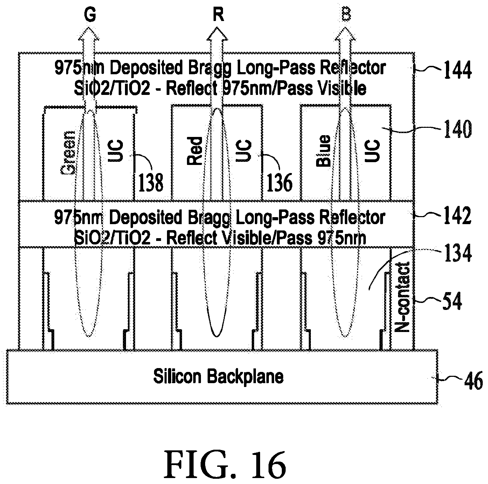

Fig. 16 illustrates another type of LED pixels where all the LEDs 134 emit infrared pump light (e.g., 975nm wavelength), and the light is converted to either red, green, or blue using a red up converter material 136, a green up converter material 138, and a blue up converter material 140. A first DBR layer 142 passes the IR pump light and reflects visible wavelength light. A second DBR layer 144 passes the visible light and reflects back the IR light for improved efficiency. The growth substrate is GaAs.

The individual pillars may also be resonant cavity LEDs or vertical cavity surface emitting lasers.

Although the device described herein is a full color display using pillars of LED pixels, similar techniques may be used to form an array of vertical transistors, photo-detectors and other semiconductor devices.

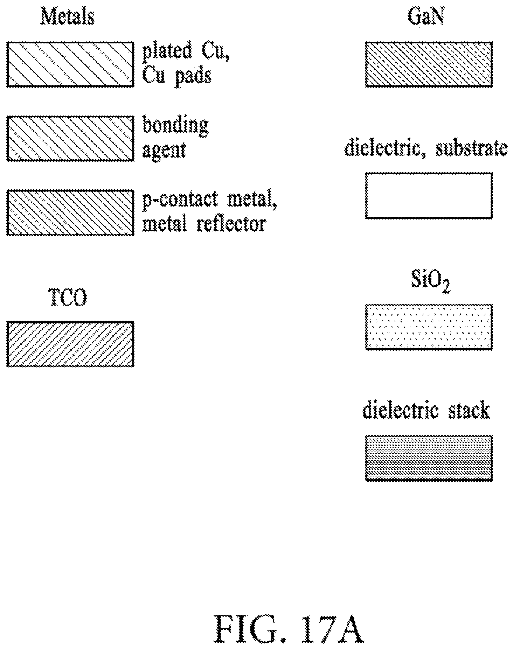

Fabrication processing preferably is performed on a wafer scale. Figs. 17A-3N show another process for manufacturing a femtoprojector display using the frontplane and backplane of Figs. 1A-1B. Fig. 17A is a legend that shows the cross hatch patterns used in this series of figures. Metals and other conductive materials are represented by a diagonal cross-hatch pattern. TCO is a transparent conductive oxide, for example indium tin oxide, aluminum zinc oxide, indium zinc oxide, indium cadmium oxide, and carbon nanotube layers. GaN is the gallium nitride region that includes the active region of the LED. GaN is a direct bandgap III-V semiconductor material that is well-suited for making LEDs. In Fig. 17A, dielectric and silicon dioxide (SiO₂) are materials that can provide electrical isolation, and the dielectric stack is used to provide wavelength selectivity.

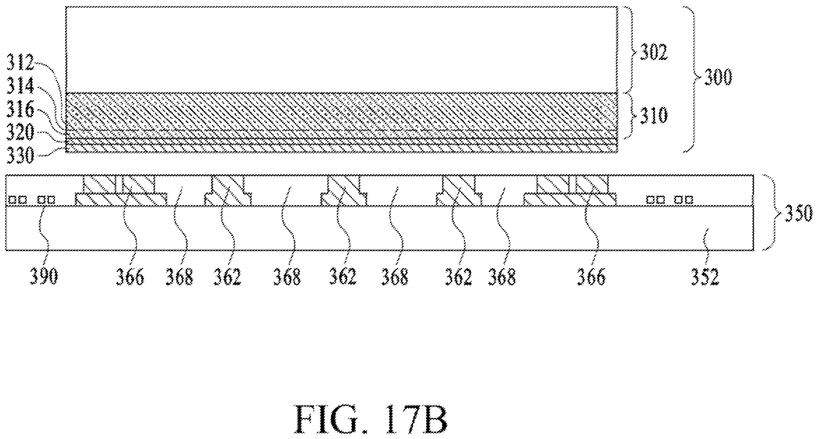

Fig. 17B shows a frontplane wafer 300 and a separate backplane wafer 350. The frontplane wafer 300 contains a GaN region 310 that is epitaxially grown on a substrate 302, which will be referred to as the frontplane substrate. Starting from the substrate, the GaN region 310 includes a buffer region (not labelled), an n-doped region 312, the active region 314 (represented by the dashed line) and a p-doped region 316. Typically, the GaN region 310 may have a total thickness of approximately 4-6 µm. The active region 314 typically is very thin, for example 0.1um or less if an InGaN multiple quantum well structure is used. The p-doped region 316 is also thin, perhaps 0.2 µm and typically less than 0.5 µm. The remainder is the n-doped region 312 and buffer region, which is relatively thick. This is because some thickness is required to allow the GaN growth to reach a sufficient quality. The GaN directly adjacent to the substrate 302 is a buffer region of poor quality.

P-contact metal 320 provides electrical contact to the p-doped region 316. In some designs, it also acts as a reflector for light generated by the active region 314. Examples of substrate 302 include sapphire. Other examples include silicon and silicon carbide. The frontplane wafer 300 in Fig. 17B is unpatterned. That is, the GaN region 310 has not yet been patterned into individual LEDs. This significantly reduces alignment requirements in attaching the frontplane wafer 300 to the backplane wafer 350.

The backplane wafer 350 contains LED driver circuits on a substrate 352. Fig. 17B does not show the actual LED driver circuits but shows copper pads 362,366 that are used to make electrical contact between the driver circuits and the LED contacts. Copper pads 366 provide electrical connection from the n-contacts of all of the LEDs to a common cathode on the backplane. Copper pads 362 provide connection from the p-contact metal 320 of each LED to the addressable driver circuitry for that LED. The fill 368 between copper pads 362,366 may be SiO₂ or SiNₓ, which is used as an etch stop in subsequent processing steps. Typically, the backplane wafer 350 is a processed CMOS on silicon wafer. Fig. 17B also shows some alignment marks 390.

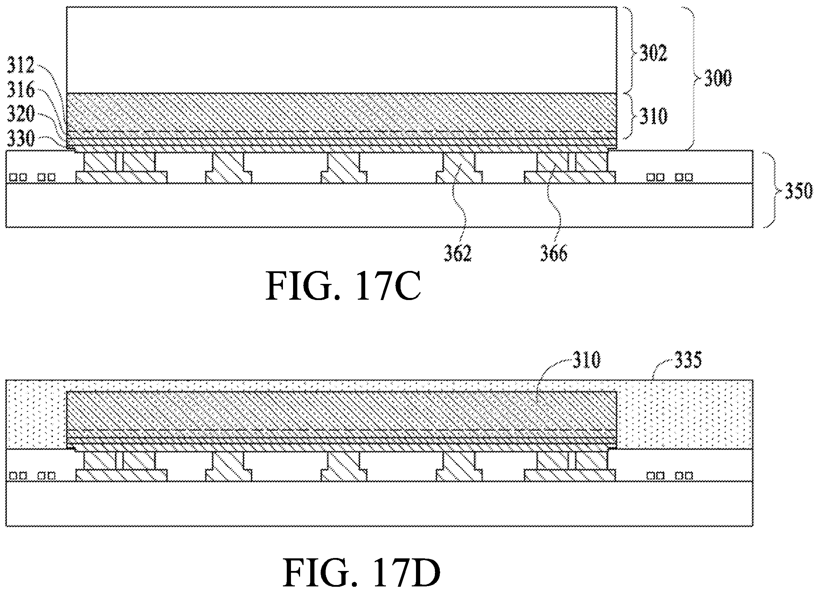

The frontplane wafer 300 is attached to the backplane wafer 350, resulting in the structure of Fig. 17C. In the example shown, the attachment is performed by non-solder surface bonding (e.g. by surface diffusion) between the p-contact metal 320 and the copper pads 362,366. A conductive bonding agent 330 is deposited on the p-contact metal 320 of the frontplane wafer. Examples of bonding agents include aluminum, indium tin oxide, aluminum-doped zinc oxide and aluminum with a surface coating of silicon, germanium or titanium to prevent oxidizing of the aluminum. The bonding agent 330 bonds to the copper pads 362,366. This mechanically attaches the two wafers to each other. It also provides an electrical connection between the p-contact metal 320 and the copper pads 362,366. This bonding step requires only rough alignment because the GaN region 310 has not yet been patterned into individual pixels. The bonding agent 330 may be selected to be compatible with further silicon wafer processing, and the bonding process itself occurs at temperatures and pressures that do not affect the already processed CMOS structures on the backplane.

In an alternative approach, both metal layers may be coated with a bonding agent. In this example, both the p-contact metal 320 and the copper pads 362,366 may be coated with a bonding agent and then bonded together.

In an alternative approach, the frontplane wafer 300 is coated with a solder, such as Sn or In, and attached to the backplane wafer 350 using solder bonding. The copper pads 362, 366 may also be coated with solder in this method.

After the two wafers 300,350 are bonded together, the frontplane substrate 302 is removed. Laser liftoff may be used to remove the sapphire substrate 302. Chemical approaches may also be used to remove the sapphire substrate 302. This exposes the buffer region of the GaN 310. Removal of the sapphire substrate 302 can create substantial shock, so doing that step before patterning the GaN region 310 is helpful from a standpoint of mechanical stability.

As shown in Fig. 17D, a dielectric fill such as silicon dioxide 335 is deposited to planarize the surface. Examples of other materials include SiN, benzocyclobutene (BCB), and spin-on glass.

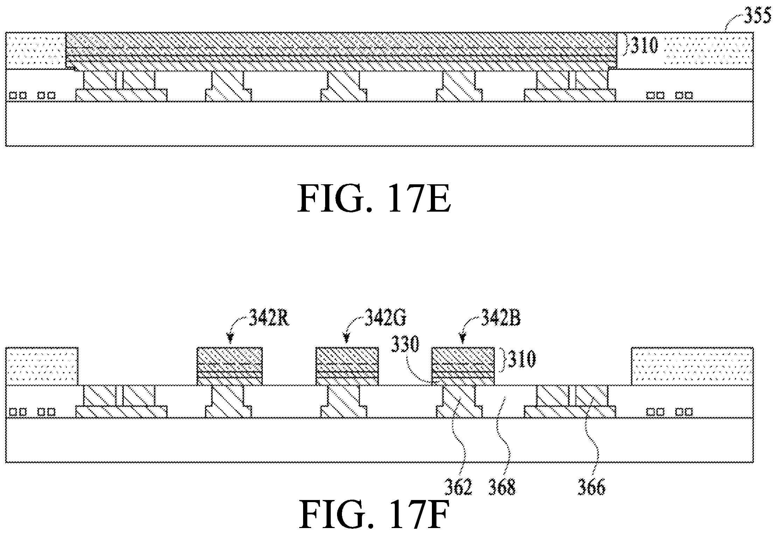

The GaN region 310 is thinned, resulting in the structure of Fig. 17E. Chemical mechanical polishing and/or a blanket dry etch may be used to reduce the thickness of the GaN region 310. Thinning removes most or all of the GaN buffer region.

As shown in Fig. 17F, the GaN region is patterned into individual LED pillars 342R,G,B, which form the LEDs for red, green and blue color pixels for the display. In one approach, a deep etch is performed through the GaN region 310 and conductive bonding layer 330. The etch stops at the surface of the SiNₓ/SiO₂ region 368. This also exposes the pads 366 for the common cathode.

The GaN region 310 of Fig. 17E is patterned into the individual LED pillars 342 of Fig. 17F by etching trenches between the pillars. These trenches may be 0.2-0.3 µm wide. If the GaN were not thinned, the gaps between pillars would be 6um tall and 0.2-0.3 µm wide for a height:width aspect ratio in the range of 20-30. It is difficult to etch a narrow trench with such a high aspect ratio. It is also difficult to further process narrow trenches, such as coating or filling them. Thinning the GaN region reduces the aspect ratio of the trenches, which makes etching and other processes easier.

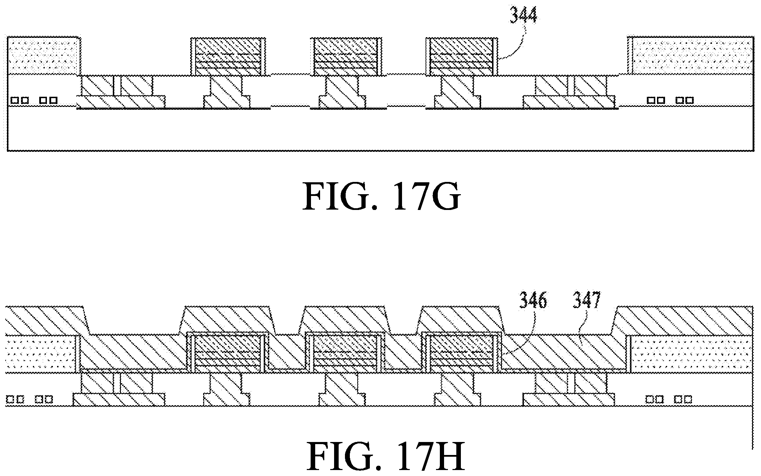

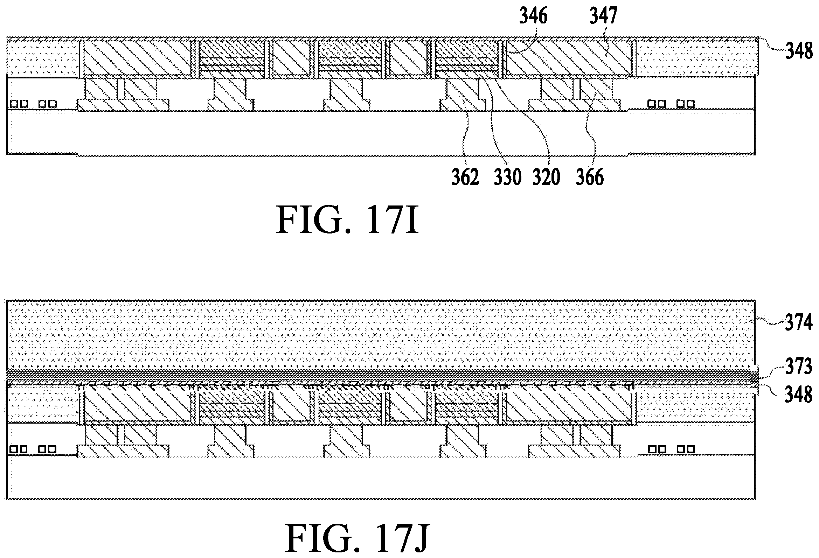

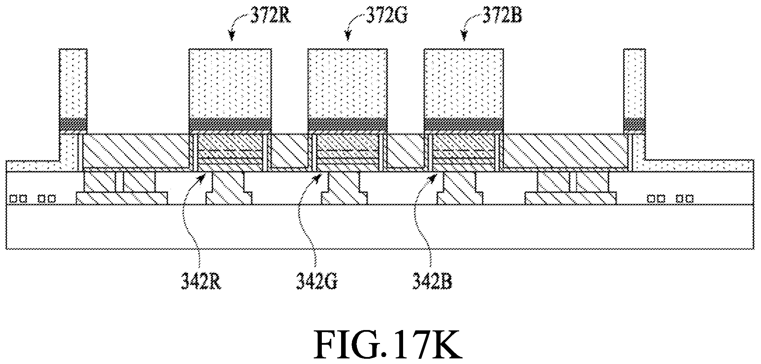

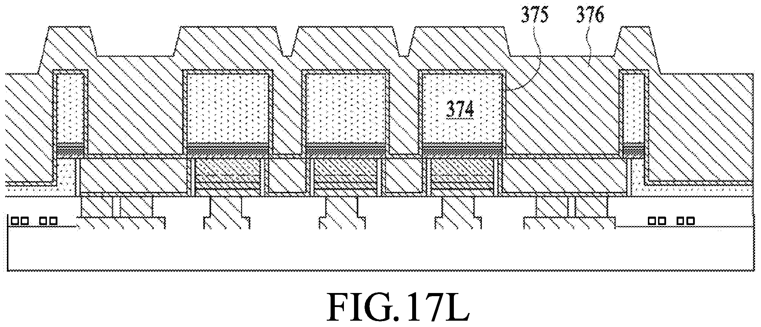

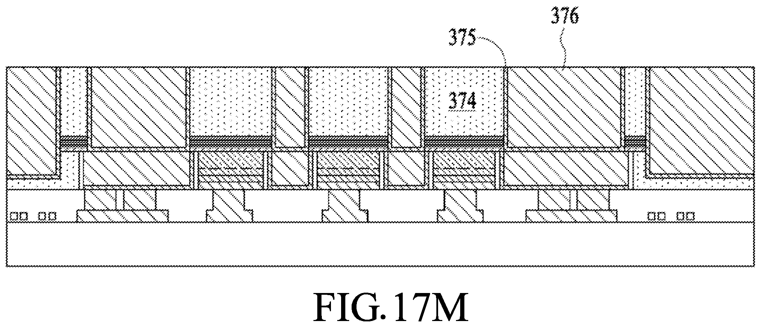

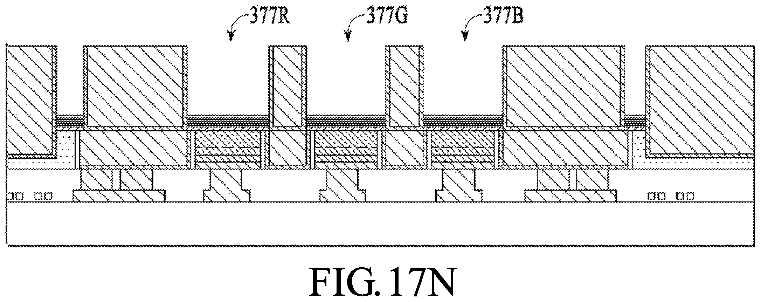

Thinning the GaN region also reduces the aspect ratio of the LED pillars 342, which improves their optical performance. Fig. 17 is not drawn to scale. Rather, the figures are drawn to illustrate the order of process steps and spatial relationships between various material layers. The LED pillars 342 without thinning may be 4-6 µm all and 0.5-1 µm wide, for a height:width aspect ratio in the range of 4-12. Thinning the GaN region may remove 2-4 µm of material, reducing the LED pillar to a height of not more than 2 µm and reducing the aspect ratio by a factor of 2x to 3x.

Note that some areas of the bonding agent 330 are etched away when the GaN pixels are patterned. The conductive bonding agent 330 is selected so that it does not coat (e.g. sputtered as an etch byproduct) the sidewalls of the GaN LED pillars 342 in order to prevent shorting of the LEDs.

In Fig. 17G, the sidewalls of the LED pillars 342 are passivated. In one approach, atomic layer deposition is used to deposit a passivation material 344 over the entire structure, including on both the tops and sidewalls of the LED pillars 342. Example passivation materials include Al₂O₃, TiO₂, SiO₂, SiNx, HfOx, and NbOx. A directional etch is used to etch the passivation material 344. This removes the passivation material from the horizontal surfaces, including the tops of the individual LED pillars, but leaves the passivation material on the sidewalls of the LED pillars. This approach does not require any lithography or fine alignment. The passivation material 344 electrically insulates the sides of the LED pillars 342 to prevent shorting of the LEDs.

The electrical connection between the LED pillars 342 and the common cathode 366 are formed in Figs 3H-3I. In Fig. 17H, a thin, reflective metal lining 346 such as aluminum or ruthenium is deposited, followed by a fill metal 347 such as copper, aluminum or gold. This is planarized via chemical mechanical polishing to expose the GaN surface. In Fig. 17I, a thin layer of a transparent conductive oxide 348 (e.g. ITO) is deposited as a current spreading layer that provides an electrical connection to each pixel.

This completes the LED structures in the femtoprojector. Referring to Fig. 17I, the individual p-contacts for each LED are from the p-contact metal 320 through the conductive bonding agent 330 to the copper pad 362 to the addressable driver circuit. The n-contacts for all LEDs are through the transparent conductive oxide 348 to the metal 346/347 to the copper pad 366 to the common cathode.

Note that this process uses only one lithographic step. In Fig. 17F, fine resolution lithography is used to align the LED pillars 342 with their corresponding driver pads 362. However, insulating the sidewalls of the pillars (Fig. 17G) and forming the electrical network to the top contact of the individual LED pillars (Figs. 17H-17I) are done without any lithography steps.

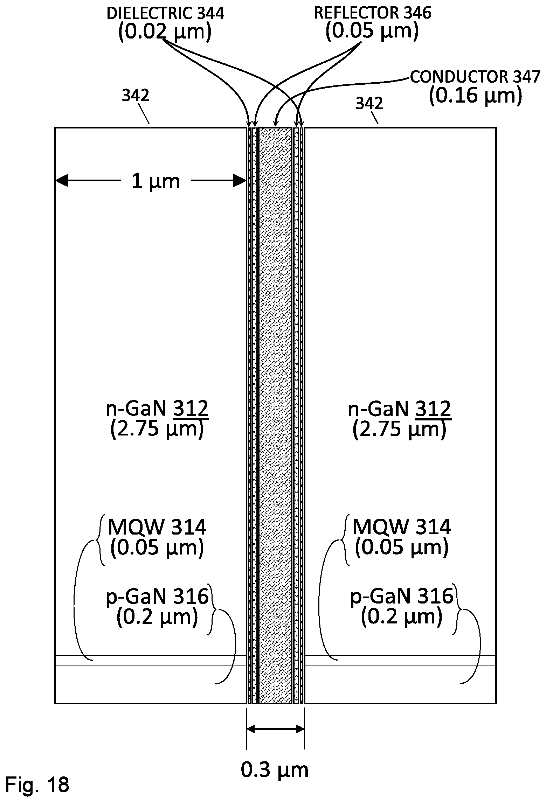

Fig. 18 shows a cross-sectional view of two adjacent LED pillars 342. Fig. 18 is drawn to scale using specific dimensions for the sake of illustration, but LED displays can be constructed using other dimensions. In this example, the LED pillars 342 include 2.75 µm of n-doped GaN 312, 0.05 µm of InGaN multiple quantum well action region 314, and 0.2 µm of p-doped GaN 316. Light is generated at the active region 314, so the optical path from the active region to the exit of the LED at the far end of the n-doped region 312 is 2.75 µm long. If the LED pillar is 1 µm wide, then this optical path has a height:width aspect ratio of 2.75:1. Light may reflect multiple times from the sidewalls before reaching the exit. Each reflection introduces some optical loss.

As described above, the sides of the LED pillar 342 are coated with a dielectric 344 (0.02 µm), a metal layer 346 that acts as a bottom reflector (0.05 µm) and metal fill 347 (0.16 µm) which provides structural support and may also provide electrical connection to the common cathode pads. In order to fabricate these structures, with a 3 µm tall LED pillar, a 3 µm all and 0.3 µm wide trench is first etched between the LED pillars. This is a trench with a height:width aspect ratio of 10:1. The trench is 3 µm deep because it electrically isolates the p-doped GaN 316 from adjacent pixels. The trench also extends through bottom metal 320 and bonding agent 330 so the total trench depth may be more than 3 µm. The sidewalls are then conformally coated with the dielectric 344 and the reflector 346. This narrows the trench to 0.16 µm (but still 3 µm tall), when it is filled with metal 347.

If the GaN region had not been thinned, the LED pillar 342 would have been even taller, say 6 µm tall. At this height, the optical path from active region 314 to exit would have an aspect ratio of 5.75:1, more than doubling the number of reflections before exiting the LED. In addition, the trench to be etched would have an aspect ratio of 20:1 and the metal fill 347 would occupy a space with aspect ratio of almost 40:1.

The dimensions given above are just examples. Typical ranges are the following. For the gap between pillars: 0.2-1 µm for the full gap width, 0.01-0.05 µm for dielectric 344 and 0.03-0.10 µm for reflector 346. For the LED pillar: 1-5 µm for n-GaN 312, 0.05 ± 0.025µm for MQW 314, and 0.2 ± 0.1 µm for p-GaN 316. Below the GaN (not shown in Fig. 18): <50nm for p-contact metal 320 (ITO, Ag, or NiAu) and <1 µm for bonding agent 330.

Returning to Fig. 17, the steps in Figs. 17A-17I were described in the context of attaching an LED frontplane wafer 300 to a silicon CMOS backplane wafer 350. This could also be done at the die level. For example, an LED frontplane wafer may be diced and individual, or groups of, LED frontplane dies 300 attached to corresponding backplane dies 350. The backplane dies may also be in wafer form or already diced into individual or groups of dies.

Figs. 17J-17N show additional steps to add color conversion materials, which in this example are quantum dot materials. In Fig. 17J, a multi-layer dielectric stack 373 is deposited on the top surface. The dielectric stack 373 provides wavelength selectivity. For example, if the LEDs produce blue light, then the dielectric stack 373 may be designed to transmit blue light and reflect red and green light. A sacrificial layer 374, such as a thick oxide (e.g., SiO₂ or SiNₓ) is deposited on the dielectric stack 373. In Fig. 17K, the dielectric stack 373 and thick oxide 374 are patterned into pillars 372R,G,B aligned with the LED pillars 342R,G,B. In Fig. 17L, a thin, reflective metal lining 375 such as aluminum or ruthenium is deposited, followed by a fill metal 376 such as copper or aluminum. In Fig. 17M, this is planarized via chemical mechanical polishing to expose the oxide 374. In Fig. 17N, the sacrificial layer 374 is removed, for example using a wet or dry chemical etch. This leaves a space 377 into which color conversion material may be deposited. A typical height for the space 377 is in a range of 1-3 µm. Different materials may be deposited into different spaces 377, for example a quantum dot material 377R for color conversion from blue to red, a quantum dot material 377G for color conversion from blue to green, and no material 377B for the blue pixel. Another alternative is light scattering particles (e.g. TiO₂) for the blue pixel.

Alternatively, the color conversion layers may be formed as a separate die and then attached to the LED die on top of the backplane. This is then singulated to form separate femtoprojector displays, typically with width less than 1mm.

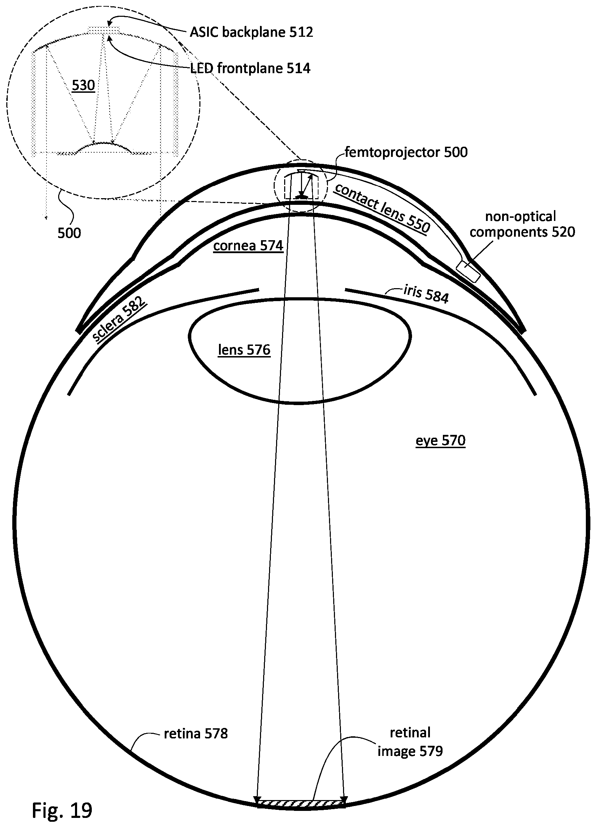

One possible use of such a monolithic ultra-dense LED display is to embed the display in a contact lens so that the displayed image overlays (or replaces) the wearer's view of the real world. Fig. 19 shows a cross sectional view of an eye-mounted display containing a femtoprojector 500 in a contact lens 550.

Fig. 19 shows an example using a scleral contact lens which is preferred because scleral lenses are designed to not move on the cornea, but the contact lens does not have to be scleral. The aqueous of the eyeball is located between the cornea 574 and the crystalline lens 576 of the eye. The vitreous fills most of the eyeball including the volume between the crystalline lens 576 and the retina 578. The iris 584 limits the aperture of the eye.

The contact lens 550 preferably has a thickness that is less than two mm, and the femtoprojector 500 preferably fits in a 2 mm by 2 mm by 2 mm or smaller volume. The contact lens 550 is comfortable to wear and maintains eye health by permitting oxygen to reach the cornea 574. The femtoprojector 500 includes an image source 512/514 and an optical system 530. The image source includes a backplane 512 and a frontplane 514, examples of which have been described above. In this example, the backplane 512 is a CMOS application specific integrated circuit (ASIC) and the frontplane 514 includes a GaN LED array. The backplane electronics 512 receive data packets from a source external to the eye-mounted display. The backplane ASIC 512 converts the data packets to drive currents for the frontplane GaN LED array 514, which produces light that is projected by the optical system 530 to the user's retina 578.

The array of light emitters 514 may have non-uniform resolution. For example, the central area of the array may be imaged onto the fovea and therefore the center pixels have higher resolution (i.e., smaller pitch between pixels) compared to pixels on the periphery of the array. The pitches of the frontplane 512 and backplane 514 may be matched, in which case there is less area for each pixel driver in the center of the backplane compared to the periphery. Alternately, the backplane 514 may have a uniform pitch, where the frontplane 512 still has a variable pitch. In one approach, a wiring layer bridges between the uniform pitch backplane 514 and variable pitch frontplane 512. By using different wiring layers, the same backplane may be used with different frontplanes.

Eye-mounted femtoprojector displays may use a 200x200 array of color pixels. The display may be monochromatic or color. A three-color display with three LEDs per color pixel may have a total of at least 120,000 LEDs.

Another possible use of the monolithic ultra-dense LED display is in eyewear, such as glasses or goggles, to create an immersive visual experience or an image that overlays the wearer's view of the real world, such as in an augmented, mixed, or artificial reality application.

Although the detailed description contains many specifics, these should not be construed as limiting the scope of the invention but merely as illustrating different examples. It should be appreciated that the scope of the disclosure includes other embodiments not discussed in detail above. Various other modifications, changes and variations which will be apparent to those skilled in the art may be made in the arrangement, operation and details of the method disclosed herein without departing from the scope as defined in the appended claims. Therefore, the scope of the invention should be determined by the appended claims.

## Claims

1. A method for manufacturing a femtoprojector display, the method comprising:
attaching a frontplane die (300) to a backplane die (350), the backplane die comprising an array of LED driver circuits on a backplane substrate, and the frontplane die comprising an unpatterned gallium nitride region (310) grown on a frontplane substrate (302);
removing the frontplane substrate;
thinning the unpatterned gallium nitride region; and
patterning the gallium nitride region into individual LED pillars (342) having an active region of width not more than 2 µm, where thinning the gallium nitride region reduces a height of the individual LED pillars as measured from the active region to a top of the gallium nitride region to less than 3 µm.

2. The method of claim 1 where growth of the gallium nitride region on the frontplane substrate results in a buffer region in the gallium nitride region adjacent to the frontplane substrate, and thinning the gallium nitride region removes the buffer region.

3. The method of claim 1 where one of:
thinning the gallium nitride region reduces a ratio of the height to the width to less than 5:1; and
thinning the gallium nitride region reduces a thickness of the gallium nitride region by at least 3 µm.

4. The method of claim 1 where attaching the frontplane die to the backplane die comprises bonding a metal layer on the frontplane die to a metal layer on the backplane die.

5. The method of claim 4 where the bonding uses a bonding agent selected from aluminum; indium tin oxide; aluminum-doped zinc oxide; aluminum with a surface coating of silicon, germanium or titanium; Sn solder and In solder.

6. The method of claim 4 where the backplane substrate is a silicon substrate, the LED driver circuits are CMOS circuits, and the metal layer on the backplane substrate is a copper layer.

7. The method of claim 1 where removing the frontplane substrate comprises using a liftoff process to remove the frontplane substrate.

8. The method of claim 1 where patterning the gallium nitride region into individual LED pillars comprises dry etching trenches into the gallium nitride region to pattern the individual LED pillars.

9. The method of claim 8 where one of:
the trenches separating adjacent individual LED pillars have a width of not more than 0.5 µm; and
the trenches separating adjacent individual LED pillars have a height-to-width aspect ratio of at least 4:1.

10. The method of claim 1 further comprising:
after removing the frontplane substrate, planarizing the frontplane die before thinning the gallium nitride region.

11. The method of claim 1 where patterning the gallium nitride region into individual LED pillars comprises:
lithographically masking areas of the gallium nitride region to define the individual LED pillars; and
etching trenches into areas of the gallium nitride region that are not masked; where the method further comprises, without any lithography steps:
passivating sidewalls of the individual LED pillars; and
forming electrical contacts to top contacts of the individual LED pillars.

12. The method of claim 11 where passivating sidewalls of the individual LED pillars comprises:
using atomic layer deposition to deposit a passivation material on the sidewalls and tops of the individual LED pillars; and
without a use of lithography, etching the deposited passivation material to remove the passivation material from the tops of the individual LED pillars but leaving passivation material on the sidewalls of the individual LED pillars.

13. The method of claim 11 further comprising:
depositing a multi-layer dielectric stack on a top surface of the individual LED pillars, the multi-layer dielectric stack providing wavelength selectivity.

14. The method of claim 13 further comprising:
depositing a sacrificial layer on the multi-layer dielectric stack;
patterning the multi-layer dielectric stack and sacrificial layer into individual pillars aligned with the individual LED pillars;
depositing fill material in spaces between the individual pillars of the sacrificial layer;
removing the sacrificial layer to create voids defined by the fill material; and
filling at least some of the voids with wavelength-conversion material that converts light produced by the individual LED pillars to a different wavelength, where the multi-layer dielectric stack passes light from the individual LED pillars and reflects light converted to the different wavelength.

15. The method of claim 14 where the wavelength-conversion material includes quantum dots.

## Patentansprüche

1. Verfahren zum Herstellen einer Femtoprojektoranzeige, wobei das Verfahren Folgendes umfasst:
Anbringen eines Frontplane-Dies (300) an einem Backplane-Die (350), wobei der Backplane-Die eine Anordnung von LED-Treiberschaltungen auf einem Backplane-Substrat umfasst und der Frontplane-Die einen unstrukturierten Galliumnitridbereich (310) umfasst, der auf einem Frontplane-Substrat (302) gewachsen ist;
Entfernen des Frontplane-Substrats;
Ausdünnen des unstrukturierten Galliumnitridbereichs; und
Strukturieren des Galliumnitridbereichs in einzelne LED-Säulen (342), die eine aktive Zone von maximal 2 µm Breite aufweisen, wobei das Ausdünnen des Galliumnitridbereichs
eine Höhe der einzelnen LED-Säulen gemessen von dem aktiven Bereich bis zur Oberkante des Galliumnitridbereichs auf weniger als 3 µm reduziert.

2. Verfahren nach Anspruch 1, wobei das Wachstum des Galliumnitridbereichs auf dem Frontplane-Substrat zu einem Pufferbereich in dem an das Frontplane-Substrat angrenzenden Galliumnitridbereich führt und der Pufferbereich durch Ausdünnen des Galliumnitridbereichs entfernt wird.

3. Verfahren nach Anspruch 1, wobei:
Ausdünnen des Galliumnitridbereichs ein Verhältnis von Höhe zu Breite auf weniger als 5:1 reduziert; und
Ausdünnen des Galliumnitridbereichs eine Dicke des Galliumnitridbereichs um mindestens 3 µm reduziert.

4. Verfahren nach Anspruch 1, wobei das Anbringen des Frontplane-Dies an dem Backplane-Die das Verbinden einer Metallschicht auf dem Frontplane-Die mit einer Metallschicht auf dem Backplane-Die umfasst.

5. Verfahren nach Anspruch 4, wobei das Verbinden ein Bindemittel verwendet, das aus Aluminium; Indiumzinnoxid; aluminiumdotiertem Zinkoxid; Aluminium mit einer Oberflächenbeschichtung aus Silizium, Germanium oder Titan; Sn-Lot und In-Lot ausgewählt ist.

6. Verfahren nach Anspruch 4, wobei es sich bei dem Backplane-Substrat um ein Siliziumsubstrat, bei den LED-Treiberschaltungen um CMOS-Schaltungen und bei der Metallschicht auf dem Backplane-Substrat um eine Kupferschicht handelt.

7. Verfahren nach Anspruch 1, wobei Entfernen des Frontplane-Substrats durch einen Lift-off-Prozess zum Entfernen des Frontplane-Substrats erfolgt.

8. Verfahren nach Anspruch 1, wobei Strukturieren des Galliumnitridbereichs in einzelne LED-Säulen das Trockenätzen von Gräben in dem Galliumnitridbereich zum Strukturieren der einzelnen LED-Säulen umfasst.

9. Verfahren nach Anspruch 8, wobei:
die Gräben, die angrenzende einzelne LED-Säulen trennen, eine Breite von maximal 0,5 µm aufweisen; und
die Gräben, die angrenzende einzelne LED-Säulen trennen, ein Höhen-Breiten-Verhältnis von mindestens 4:1 aufweisen.

10. Verfahren nach Anspruch 1, weiter Folgendes umfasst:
nach dem Entfernen des Frontplane-Substrats, Planarisieren des Frontplane-Dies, bevor der Galliumnitridbereich ausgedünnt wird.

11. Verfahren nach Anspruch 1, wobei das Strukturieren des Galliumnitridbereichs in einzelne LED-Säulen Folgendes umfasst:
lithografisches Maskieren von Flächen des Galliumnitridbereichs, um die einzelnen LED-Säulen zu definieren; und
Ätzen von Gräben in nicht maskierten Flächen des Galliumnitridbereichs; wobei das Verfahren weiter ohne Lithographieschritte Folgendes umfasst:
Passivieren der Seitenwände der einzelnen LED-Säulen; und
Bilden elektrischer Kontakte zu den oberen Kontakten der einzelnen LED-Säulen.

12. Verfahren nach Anspruch 11, wobei Passivieren der Seitenwände der einzelnen LED-Säulen Folgendes umfasst:
Verwenden von Atomlagenabscheidung zum Abscheiden eines Passivierungsmaterials auf den Seitenwänden und Oberseiten der einzelnen LED-Säulen; und
ohne Verwendung von Lithographie, Ätzen des abgeschiedenen Passivierungsmaterials, um das Passivierungsmaterial von den Oberseiten der einzelnen LED-Säulen zu entfernen, während das Passivierungsmaterial an den Seitenwänden der einzelnen LED-Säulen erhalten bleibt.

13. Verfahren nach Anspruch 11, das weiter Folgendes umfasst:
Abscheiden eines mehrschichtigen dielektrischen Stapels auf einer Oberseite der einzelnen LED-Säulen, wobei der mehrschichtige dielektrische Stapel Wellenlängenselektivität bereitstellt.

14. Verfahren nach Anspruch 13, weiter Folgendes umfasst:
Abscheiden einer Opferschicht auf dem mehrschichtigen dielektrischen Stapel;
Strukturieren des mehrschichtigen dielektrischen Stapels und der Opferschicht in einzelne Säulen, die mit den einzelnen LED-Säulen ausgerichtet sind;
Abscheiden von Füllmaterial in den Zwischenräumen zwischen den einzelnen Säulen der Opferschicht;
Entfernen der Opferschicht, um durch das Füllmaterial definierte Hohlräume zu schaffen; und
Füllen mindestens einiger der Hohlräume mit Wellenlängenkonversionsmaterial, das das von den einzelnen LED-Säulen erzeugte Licht in eine unterschiedliche Wellenlänge umwandelt, wobei der mehrschichtige dielektrische Stapel das Licht von den einzelnen LED-Säulen durchlässt und das in die unterschiedliche Wellenlänge umgewandelte Licht reflektiert.

15. Verfahren nach Anspruch 14, wobei das Wellenlängenumwandlungsmaterial Quantenpunkte beinhaltet.

## Revendications

1. Procédé de fabrication d'un dispositif d'affichage à femtoprojecteur, le procédé comprenant :
la fixation d'une puce de plan avant (300) à une puce de plan arrière (350), la puce de plan arrière comprenant un réseau de circuits de commande de DEL sur un substrat de plan arrière, et la puce de plan avant comprenant une région de nitrure de gallium non structurée (310) ayant crû sur un substrat de plan avant (302) ;
la suppression du substrat de plan avant ;
l'amincissement de la région de nitrure de gallium non structurée ; et
la structuration de la région de nitrure de gallium en piliers de DEL individuels (342) présentant une région active d'une largeur maximale de 2 µm, l'amincissement de la région de nitrure de gallium réduisant
une hauteur des piliers de DEL individuels mesurée de la région active au sommet de la région de nitrure de gallium à moins de 3 µm.

2. Procédé selon la revendication 1, dans lequel la croissance de la région de nitrure de gallium sur le substrat de plan avant résulte en une région tampon dans la région de nitrure de gallium adjacente au substrat de plan avant, et l'amincissement de la région de nitrure de gallium élimine la région tampon.

3. Procédé selon la revendication 1, dans lequel
l'amincissement de la région de nitrure de gallium réduit un rapport de la hauteur à la largeur à moins de 5:1 ; et
l'amincissement de la région de nitrure de gallium réduit une épaisseur de la région de nitrure de gallium d'au moins 3 µm.

4. Procédé selon la revendication 1, dans lequel la fixation de la puce de plan avant à la puce de plan arrière consiste à lier une couche métallique sur la puce de plan avant à une couche métallique sur la puce de plan arrière.

5. Procédé selon la revendication 4 dans lequel la liaison utilise un agent de liaison choisi parmi l'aluminium ; l'oxyde d'indium-étain ; l'oxyde de zinc dopé à l'aluminium ; l'aluminium avec un revêtement de surface en silicium, germanium ou titane ; une brasure au Sn et une brasure à l'In.

6. Procédé selon la revendication 4, dans lequel le substrat de plan arrière est un substrat en silicium, les circuits de commande de DEL sont des circuits CMOS et la couche métallique sur le substrat de plan arrière est une couche de cuivre.

7. Procédé selon la revendication 1, dans lequel l'élimination du substrat de plan avant comprend l'utilisation d'un processus de décollement pour éliminer le substrat de plan avant.

8. Procédé selon la revendication 1, dans lequel la structuration de la région de nitrure de gallium en piliers de DEL individuels comprend une gravure sèche de tranchées dans la région de nitrure de gallium pour structurer les piliers de DEL individuels.

9. Procédé selon la revendication 8, dans lequel :
les tranchées séparant des piliers de DEL individuels adjacents présentent une largeur maximale de 0,5 µm ; et
les tranchées séparant des piliers de DEL individuels adjacents présentant un rapport d'aspect hauteur/largeur d'au moins 4:1.

10. Procédé selon la revendication 1, comprenant en outre :
après avoir supprimé le substrat de plan avant, l'aplanissement de la puce de plan avant avant l'amincissement de la région de nitrure de gallium.

11. Procédé selon la revendication 1, dans lequel la structuration de la région de nitrure de gallium en piliers de DEL individuels comprend :
le masquage par lithographie des zones de la région de nitrure de gallium pour définir les piliers de DEL individuels ; et
la gravure des tranchées dans des zones de la région de nitrure de gallium qui ne sont pas masquées ; le procédé comprenant en outre, sans aucune étape de lithographie :
la passivation des parois latérales des piliers de DEL individuels ; et
la formation des contacts électriques avec des contacts supérieurs des piliers de DEL individuels.

12. Procédé selon la revendication 11, dans lequel la passivation des parois latérales des piliers de DEL individuels comprend :
l'utilisation d'un dépôt de couche atomique pour déposer un matériau de passivation sur les parois latérales et les sommets des piliers de DEL individuels ; et
sans recourir à la lithographie, la gravure du matériau de passivation déposé pour éliminer le matériau de passivation à partir des sommets des piliers de DEL individuels tout en laissant du matériau de passivation sur les parois latérales des piliers de DEL individuels.

13. Procédé selon la revendication 11, comprenant en outre :
le dépôt d'un empilement diélectrique multicouche sur une surface supérieure des piliers de DEL individuels, l'empilement diélectrique multicouche fournissant une sélectivité de longueur d'onde.

14. Procédé selon la revendication 13, comprenant en outre :
le dépôt d'une couche sacrificielle sur l'empilement diélectrique multicouche ;
la structuration de l'empilement diélectrique multicouche et de la couche sacrificielle en piliers individuels alignés avec les piliers de DEL individuels ;
le dépôt du matériau de remplissage dans les espaces entre les piliers individuels de la couche sacrificielle ;
la suppression de la couche sacrificielle pour créer des vides définis par le matériau de remplissage ; et
le remplissage d'au moins une partie des vides avec un matériau de conversion de longueur d'onde qui convertit la lumière produite par les piliers de DEL individuels en une longueur d'onde différente, dans lequel l'empilement diélectrique multicouche laisse passer la lumière provenant des piliers de DEL individuels et réfléchit la lumière convertie en la longueur d'onde différente.

15. Procédé selon la revendication 14, dans lequel le matériau de conversion de longueur d'onde inclut des points quantiques.
